# DEMANDE DE BREVET EUROPEEN

(11) **EP 4 429 436 A1**
(43) Date de publication de la demande: **11.09.2024**
(21) Numéro de dépôt: 24160152.5
(22) Date de dépôt: 28.02.2024
(51) Int. Cl.: H10B 63/00

(54) **PROCÉDÉ DE FABRICATION D'UNE PUCE ÉLECTRONIQUE COMPRENANT UN CIRCUIT MÉMOIRE**

(30) Priorité: 06.03.2023 FR 2302064
(71) Demandeur: STMicroelectronics International N.V., 1228 Plan-les-Ouates, Geneva (CH)
(72) Inventeur: BERTHELON, Remy, 38920 CROLLES (FR); WEBER, Olivier, 38000 GRENOBLE (FR)
(74) Mandataire: Cabinet Beaumont

(57) **Abrégé**

La présente description concerne un procédé comprenant la formation simultanée d'un premier transistor dans et sur une première région d'un substrat, d'un deuxième transistor dans et sur une deuxième région du substrat, d'un troisième transistor dans et sur une troisième région du substrat et d'une cellule mémoire dans et sur une quatrième région du substrat,
le procédé comprenant, les étapes successives suivantes :
b) formation d'un premier empilement sur la première région, d'un deuxième empilement sur la deuxième région, d'un troisième empilement sur la troisième région et d'un quatrième empilement en vis-à-vis de la quatrième région ;
c) graver simultanément une partie du troisième empilement et le quatrième empilement, les premier et deuxième empilements étant protégés par un premier masque ; et
f) graver simultanément le premier et le deuxième empilement, le troisième empilement et la quatrième région du substrat étant protégés par un deuxième masque.

## Description

### Domaine technique

La présente description concerne de façon générale le domaine des puces électronique et vise plus particulièrement le domaine des puces électroniques comportant un circuit mémoire à base d'un matériau à changement de phase et leurs procédés de fabrication.

### Technique antérieure

Un matériau à changement de phase est un matériau ayant la capacité de changer d'état cristallin sous l'effet de la chaleur et plus particulièrement de commuter entre un état cristallin et un état amorphe, plus fortement résistif que l'état cristallin. Ce phénomène est utilisé pour définir deux états mémoires, par exemple 0 et 1, différenciés par la résistance mesurée à travers le matériau à changement de phase.

Il existe un besoin d'amélioration des puces électroniques comportant un circuit mémoire comportant des points mémoires à base d'un matériau à changement de phase, et de leurs procédés de fabrication.

### Résumé de l'invention

Un mode de réalisation prévoit un procédé comprenant la formation simultanée, dans et sur un substrat semiconducteur :
- d'un premier transistor d'un premier type dans et sur une première région du substrat semiconducteur ;
- d'un deuxième transistor d'un deuxième type dans et sur une deuxième région du substrat semiconducteur ;
- d'un troisième transistor d'un troisième type dans et sur une troisième région du substrat semiconducteur ; et
- d'une cellule mémoire à base d'un matériau à changement de phase dans et sur une quatrième région du substrat semiconducteur,
le procédé comprenant, les étapes successives suivantes :
a) formation de tranchées d'isolation dans la quatrième région du substrat semiconducteur ;
b) formation :
   - d'un premier empilement de grille sur et en contact avec la première région du substrat semiconducteur,
   - d'un deuxième empilement de grille sur et en contact avec la deuxième région du substrat semiconducteur,
   - d'un troisième empilement de grille sur et en contact avec la troisième région du substrat semiconducteur, et
   - d'un quatrième empilement, sur et en contact avec le substrat semiconducteur en vis-à-vis de la quatrième région du substrat semiconducteur ;
c) graver simultanément une partie du troisième empilement de grille et le quatrième empilement de façon à découvrir le substrat semiconducteur dans sa quatrième région, le premier empilement de grille et le deuxième empilement de grille étant protégés par un premier masque ; et
f) graver simultanément le premier et le deuxième empilement de grille, le troisième empilement de grille et la quatrième région du substrat semiconducteur étant protégés par un deuxième masque.

Selon un mode de réalisation, le quatrième empilement est identique au troisième empilement de grille.

Selon un mode de réalisation, le procédé comporte, après l'étape f), des étapes d'épitaxie du substrat semiconducteur en vis-à-vis des première et deuxième régions du substrat semiconducteur, le troisième empilement de grille et la quatrième région du substrat semiconducteur étant protégés par le deuxième masque.

Selon un mode de réalisation, le troisième empilement de grille comprend une première couche d'isolant de grille et une couche de grille.

Selon un mode de réalisation, le premier empilement de grille comprend un empilement diélectrique, une couche métallique et une couche de grille.

Selon un mode de réalisation, le deuxième empilement de grille comprend un deuxième isolante de grille, un empilement diélectrique, une couche métallique et une couche de grille.

Selon un mode de réalisation, l'empilement diélectrique comporte une première couche diélectrique et une deuxième couche diélectrique, la deuxième couche diélectrique étant en un matériau de haute permittivité.

Selon un mode de réalisation, les tranchées isolantes sont remplies d'un oxyde.

Selon un mode de réalisation, le procédé comporte une étape de formation de cellules mémoires dans et sur le substrat semiconducteur en vis-à-vis de la quatrième région du substrat conducteur.

Un autre mode de réalisation prévoit une puce électronique comportant un circuit mémoire comportant une première couche semiconductrice disposée sur et en contact avec une deuxième couche semiconductrice dopée d'un premier type de conductivité, elle-même située sur et en contact avec une troisième couche semiconductrice dopée d'un deuxième type de conductivité opposé au premier type de conductivité,
la première couche semiconductrice comportant des zones dopées du deuxième type de conductivité,
le circuit mémoire comportant des tranchées délimitant les zones de la première couche semiconductrice, et s'étendant à partir d'une face de la première couche semiconductrice opposée à la deuxième couche semiconductrice, à travers la première couche semiconductrice et débouchant dans la deuxième couche semiconductrice, et
les zones de la première couche semiconductrice étant surmontées par des points mémoires à base de matériau à changement de phase, la deuxième couche, la troisième couche et les zones de la première couche constituant des transistors bipolaires.

Selon un mode de réalisation, la puce électronique comporte en outre un premier transistor d'un premier type dans et sur une première région) du substrat semiconducteur, un deuxième transistor d'un deuxième type dans et sur une deuxième région) du substrat semiconducteur, un troisième transistor d'un troisième type dans et sur une troisième région) du substrat semiconducteur.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1A et la figure 1B illustrent deux vues en coupe, partielles et schématiques, d'un exemple de puce électronique ;
la figure 2 illustre une vue en coupe, partielle et schématique, d'une puce électronique selon un mode de réalisation ; et
la figure 3A, la figure 3B, la figure 3C, la figure 3D, la figure 3E, la figure 3F, la figure 3G, la figure 3H, la figure 3I, la figure 3J, la figure 3K, la figure 3L, la figure 3M, la figure 3N, la figure 3O, la figure 3P, la figure 3Q, la figure 3R, la figure 3S et la figure 3T représentent un exemple de procédé de fabrication de la puce électronique illustrée en figure 2.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, des étapes de fabrication de points mémoires à changements de phase ne sont pas décrites en détails, les modes de réalisation décrits étant compatibles avec les étapes usuelles de fabrication de points mémoire à changement de phase.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

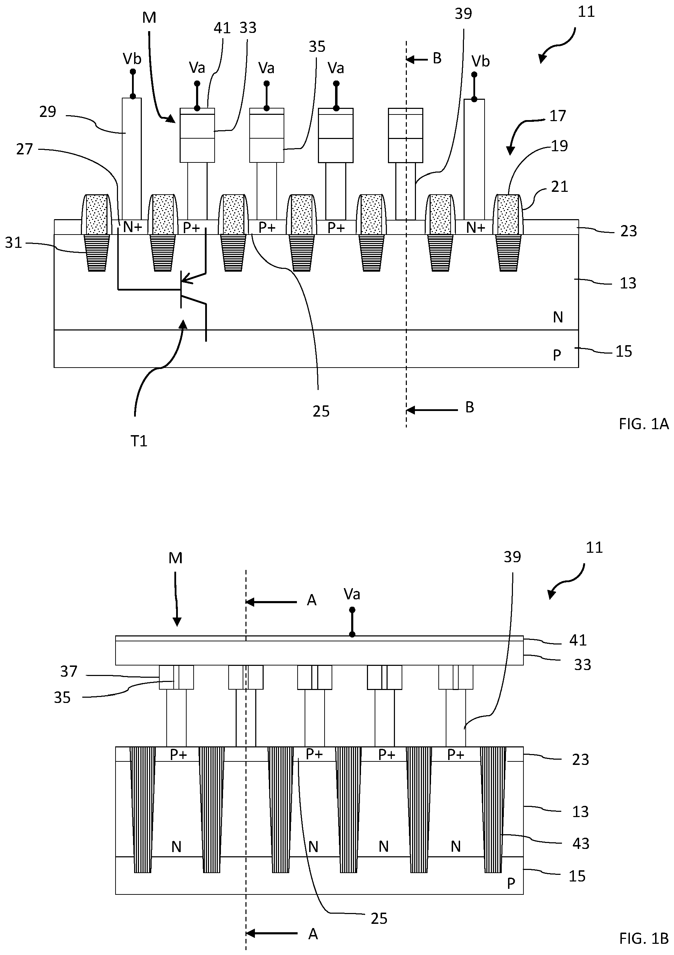

La figure 1A et la figure 1B illustrent deux vues en coupe, partielles et schématiques, d'un exemple de puce électronique 11, la figure 1A étant une vue selon le plan de coupe AA de la figure 1B et la figure 1B étant une vue selon le plan de coupe BB de la figure 1A.

Plus particulièrement, la figure 1A et la figure 1B illustrent une portion de la puce électronique 11 et plus précisément une portion d'un circuit mémoire de la puce électronique 11. A titre d'exemple, la puce électronique 11 comprend, dans une portion non représentée, un circuit logique adjacent au circuit mémoire. Les circuits logique et mémoire sont, par exemple, fabriqués simultanément dans et sur un même substrat semiconducteur.

La puce électronique 11 comprend des points mémoires M par exemple organisés, en vue de dessus, selon une matrice de lignes et de colonne. A titre d'exemple, les points mémoires M illustrés en figure 1A sont des points mémoires M d'une même ligne alors que les points mémoires illustrés en figure 1B sont des points mémoires d'une même colonne. On parle respectivement de lignes de mots (wordlines) et de lignes de bits (bitlines), chaque point mémoire M étant situé à l'intersection d'une ligne de bits et d'une ligne de mots. En figure 1A, seulement quatre lignes de bits sont représentées et en figure 1B seulement cinq lignes de mots sont représentées. Toutefois, en pratique, un circuit mémoire peut comprend un nombre de lignes de bits et de lignes de mots différent respectivement de quatre et cinq, par exemple supérieur à quatre et cinq.

A titre d'exemple, les points mémoires M sont à base d'un matériau à changement de phase 33, par exemple à base d'un matériau chalcogènure, par exemple un alliage de germanium, antimoine et tellure (GeSbTe) dit GST. Dans chaque point mémoire, le matériau à changement de phase est, par exemple, contrôlé par un élément résistif métallique chauffant 35 situé sous le matériau à changement de phase, par exemple en contact, par sa face supérieure, avec la face inférieure du matériau à changement de phase 33, et entouré latéralement d'un isolant thermique 37. Le matériau à changement de phase 33 est, par exemple surmonté par des métallisations 41, par exemple en un matériau conducteur. A titre d'exemple, dans chaque point mémoire M, les éléments métalliques 35 et 41 forment respectivement une électrode inférieure et une électrode supérieure de l'élément résistif à résistance variable formé par le matériau à changement de phase 33. A titre d'exemple, les points mémoires M d'une même ligne de bits sont surmontés d'une même métallisation 41. En d'autres termes, les électrode supérieures 41 des points mémoires M d'une même ligne de bits sont interconnectées. Les métallisations 41 sont, par exemple, couplées à des noeuds d'application de potentiels Va.

La puce 11 comprend une couche semiconductrice 13 dopée d'un premier type de conductivité, par exemple du type N, par exemple dopée d'atomes d'arsenic ou de phosphore. La couche 13 est, par exemple, en silicium. La couche 13 repose sur une couche semiconductrice 15 dopée d'un deuxième type de conductivité, opposé au premier type de conductivité, par exemple du type P, par exemple dopée d'atomes de bore. La couche 15 est, par exemple, en silicium.

A titre d'exemple, la puce 11 comprend des motifs de grille 17 (en anglais "dummy gate") disposés sur la face supérieure de la couche 13, par exemple s'étendant longitudinalement dans la direction des lignes de bits. Les motifs de grille 17 comportent, par exemple une partie centrale 19 entourée latéralement d'espaceurs 21. La partie centrale 19 de chaque motif de grille 17 est, par exemple en un matériau semiconducteur, par exemple en silicium, par exemple en silicium polycristallin. Les espaceurs 21 sont par exemple en un matériau isolant électriquement, par exemple en un nitrure de silicium.

Dans cet exemple, les motifs de grille 17 s'étendent, en vue de dessus, entre les lignes de bits de la matrice de points mémoire M. Autrement dit, dans cet exemple, en vue de dessus, deux lignes de bits consécutives quelconques de la matrice de points mémoire M sont séparées l'une de l'autre par un et un seul motif de grille 17 s'étendant sur toute la longueur desdites lignes de bit. Les motifs de grille 17 sont, par exemple séparés latéralement par une couche semiconductrice 23, par exemple formée par épitaxie à partir de la face supérieure de la couche 13. La couche 23 est, par exemple en silicium, par exemple en silicium monocristallin. A titre d'exemple, chaque point mémoire M est relié, par exemple connecté, à la couche 23 par l'intermédiaire d'un via 39. A titre d'exemple, le via 39 est en contact, par sa face supérieure, avec la face inférieure de l'élément résistif chauffant 35 du point mémoire M. Le via 39 est par exemple en contact, par sa face inférieure, avec la face supérieure de la couche 23.

La couche 23 comprend, par exemple des premières régions 25, par exemple dopées du deuxième type de conductivité, par exemple du type P, et s'étendant entre certains motifs de grille 17, à l'aplomb des points mémoires M de la matrice. Les régions 25 sont, par exemple plus fortement dopées que la couche 15. Chaque région 25 est, par exemple surmontée d'un point mémoire. A titre d'exemple, pour chaque point mémoire M, le via 39 correspondant relie électriquement l'élément chauffant 35 du point mémoire à la région 25 sous-jacente.

La couche 23 comprend, en outre, des deuxièmes régions 27, par exemple dopées du premier type de conductivité, par exemple du type N, et s'étendant entre d'autres motifs de grille 17. Les régions 27 sont, par exemple plus fortement dopées que la couche 13. Les régions 27, à la différence des régions 25, ne sont par exemple pas surmontées de points mémoires M mais de vias de reprise de contact 29. Les vias 29 permettent la reprise de contact des lignes de mots. A titre d'exemple, au sein d'une même ligne de mots, deux vias 29 sont espacés de, par exemple, quatre points mémoires M (appartenant respectivement à quatre lignes de bits consécutives). A titre d'exemple, les reprises de contact sont reliées à un noeud d'application d'un potentiel Vb appliqué à la ligne de mots concernée.

Les régions 27 et 25 sont, par exemple, délimitées latéralement par les motifs de grille 17 et par des tranchées d'isolation 31, par exemple des tranchées d'isolation très peu profondes (SSTI, de l'anglais "Super Shallow Trench Isolation"). Les tranchées d'isolation 31 empêchent, par exemple, des fuites de courant électrique entre deux lignes de bits successives. Les tranchées 31 sont alors, par exemple situées sous les motifs de grille 17. A titre d'exemple, les tranchées 31 sont linéaires et chaque motif de grille est situé sur et en contact avec une tranchée 31. A titre d'exemple, chaque tranchée 31 s'étend longitudinalement dans la direction des lignes de bits, sur toute la longueur des lignes de bits. A titre d'exemple, les tranchées 31 s'étendent, verticalement, dans la couche 13, à partir de la face supérieure de la couche 13 sur une partie seulement de l'épaisseur de la couche 13. Les tranchées d'isolation 31 sont par exemple remplies d'un matériau diélectrique, par exemple de l'oxyde de silicium. La profondeur des tranchées 31 est par exemple comprise entre 20 nm et 40 nm.

A titre d'exemple, la puce 11 comprend des tranchées d'isolation 43, par exemple des tranchées d'isolation peu profondes (STI, de l'anglais " Shallow Trench Isolation"). Les tranchées d'isolation 31 et 43 sont, par exemple orthogonale et forment une grille. La profondeur des tranchées 43 est par exemple supérieure à la profondeur des tranchées 31. Les tranchées 43 s'étendent, par exemple, à partir de la face supérieure de la couche 13, dans la couche 13 et dans une partie de la couche 15. A titre d'exemple, les tranchées 43 permettent de séparer et donc d'isoler électriquement des bandes de la couche 13 à l'aplomb respectivement de chaque ligne de mots. A titre d'exemple, chaque tranchée 43 s'étend longitudinalement dans la direction des lignes de mots, sur toute la longueur des lignes de mots. Les tranchées d'isolation 43 sont par exemple remplies d'un matériau diélectrique, par exemple de l'oxyde de silicium. La profondeur des tranchées 43 est par exemple comprise entre 300 nm et 400 nm.

Dans l'exemple des figures 1A et 1B, pour chaque point mémoire M, la zone 25 située à l'aplomb du point mémoire, la couche 13 (et la zone 27) et la couche 15 définissent un transistor bipolaire T1, ici de type PNP, de sélection du point mémoire. Chaque point mémoire M est par exemple associé à un transistor bipolaire T1. Dans cet exemple, la région 25 constitue une région d'émetteur du transistor T1, la région 13 (et la zone 27) constitue une région de base du transistor T1 et la couche 15 constitue une région de collecteur du transistor T1. A titre d'exemple, le collecteur est commun à tous les transistors T1 de la matrice et est, par exemple, connecté à la masse. Dans cet exemple, la région de base 13 est commune à tous les transistors T1 d'une même ligne de mots du circuit mémoire.

Bien que les motifs de grille 17 permettent de réduire les courants de fuite en séparant latéralement les zones 27, elles peuvent toutefois, au sein du circuit mémoire, poser certains problèmes. En effet, alors qu'un motif de grille 17 s'étend au dessus d'une tranchée d'isolation 31, celui-ci va recouvrir des tranchées d'isolation 43 formée orthogonalement. Les tranchées d'isolation 3 et 43 pouvant avoir des profondeurs différentes, les motifs de grille 17 peuvent alors se déformer à l'intersection entre une tranchée d'isolation 31 et une tranchée d'isolation 43 ce qui peut engendrer une mauvaise encapsulation du nitrure de titane formé généralement à la surface des tranchées d'isolation 31 et 43, et pouvant provoquer des courants parasites.

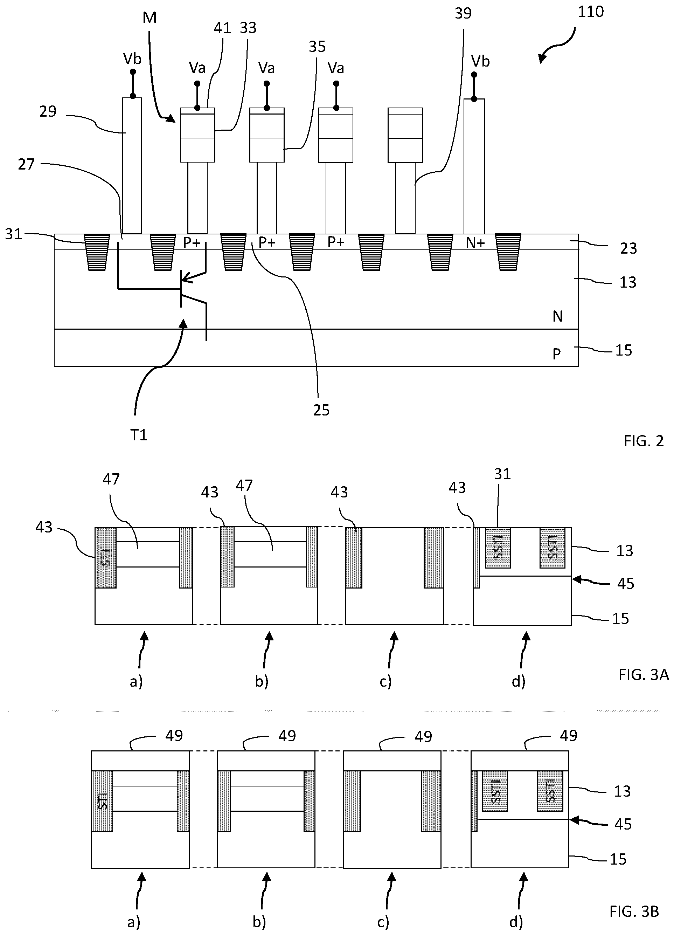

La figure 2 illustre une vue en coupe, partielle et schématique, d'une puce électronique 110 selon un mode de réalisation.

Plus particulièrement, la figure 2 illustre une puce électronique 110 similaire à la puce électronique 11 illustrée en figure 1A à la différence près que la puce électronique 110 ne comprend pas de motif de grille 17.

La puce électronique 110 diffère en outre de la puce électronique 11 en ce que la puce électronique 23 ne comprend pas, dans le circuit mémoire, de couche semiconductrice épitaxiée 23 et que les zones 27 et 25 sont formées dans la couche semiconductrice 13.

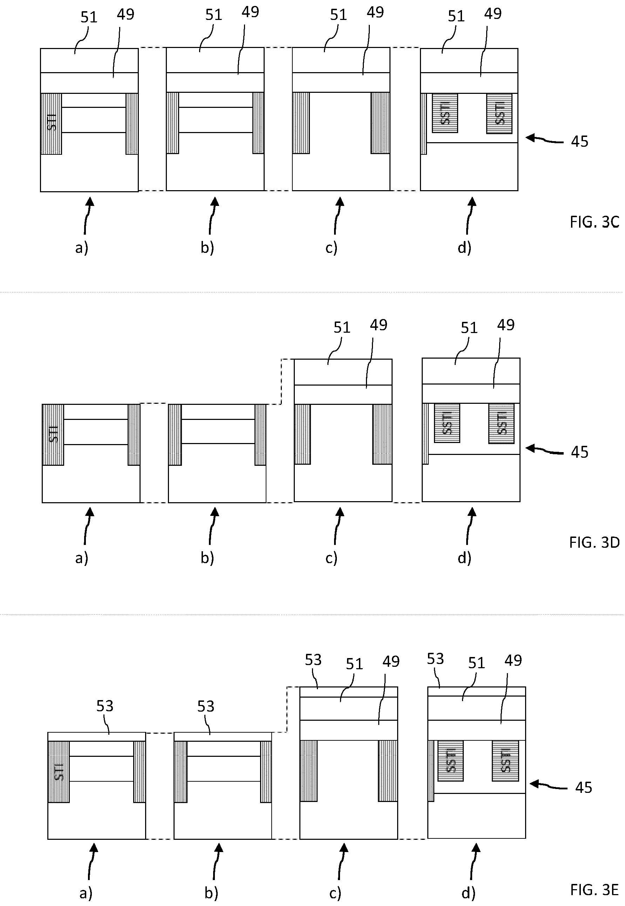

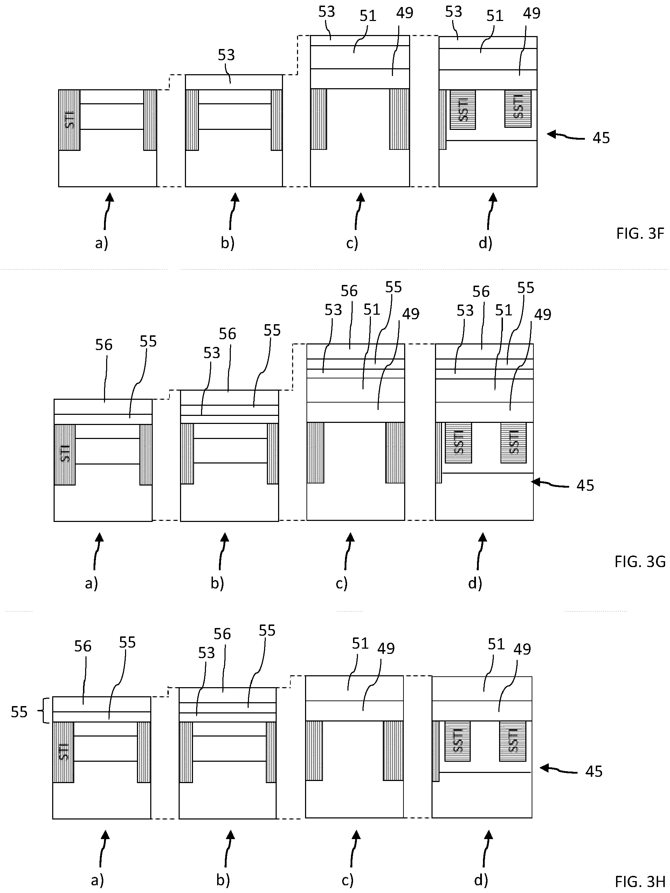

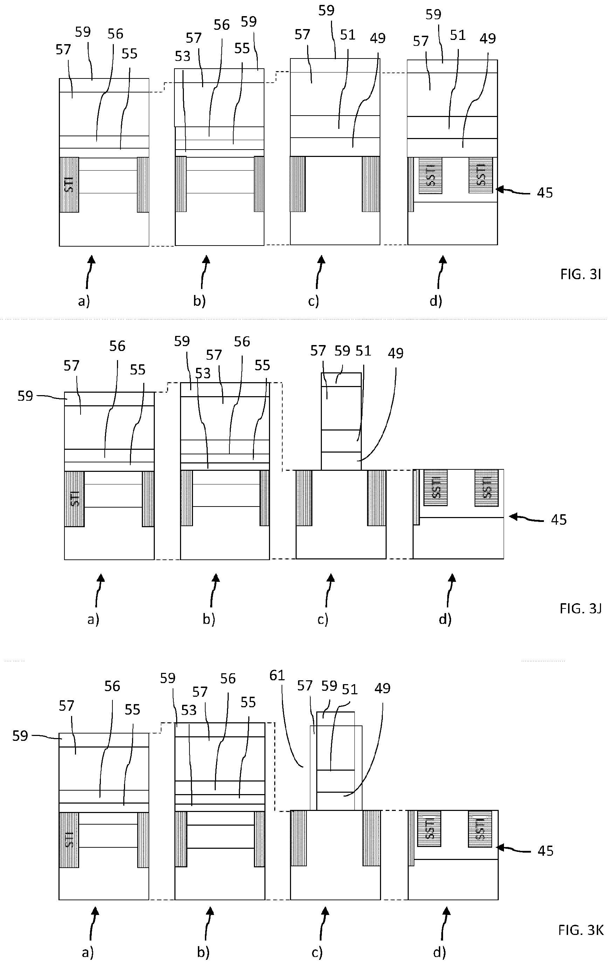

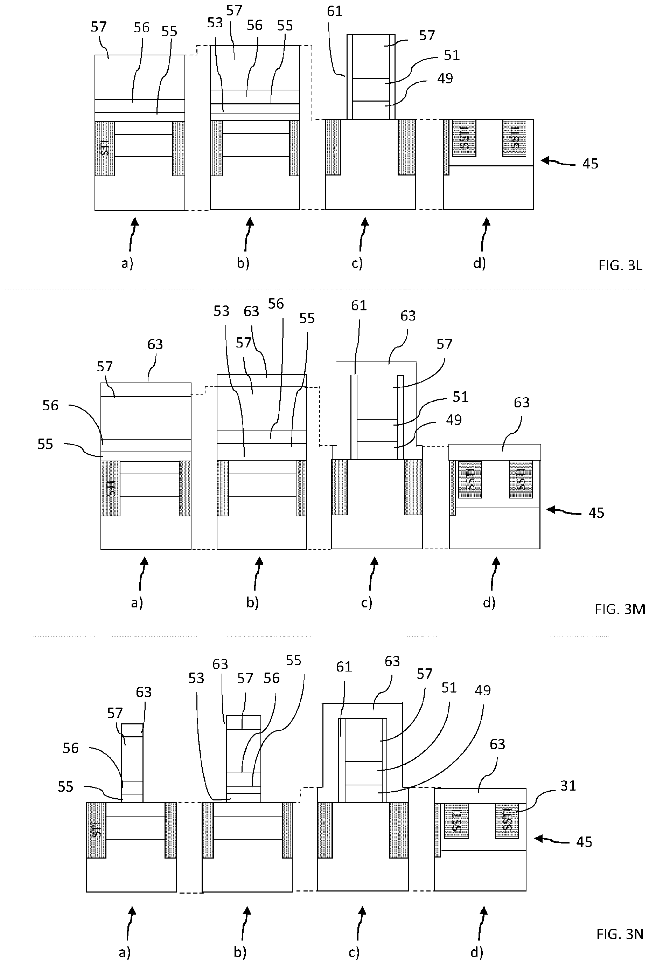

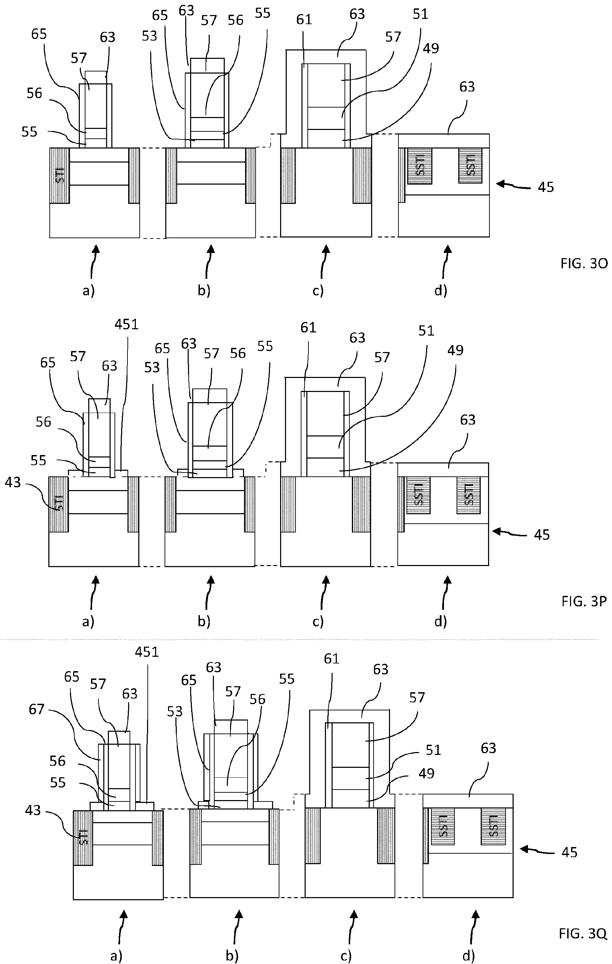

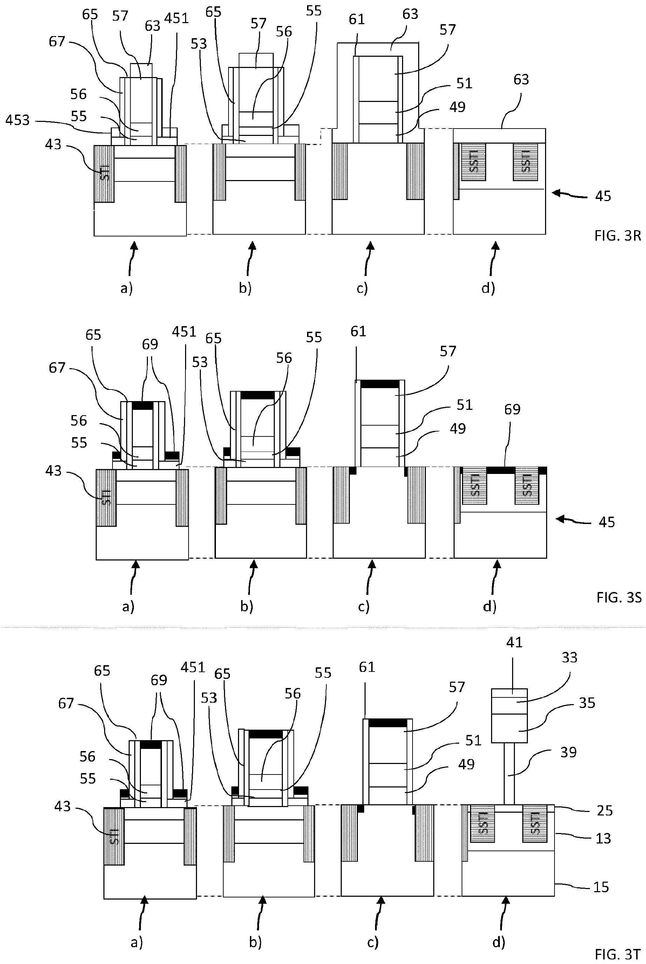

La figure 3A, la figure 3B, la figure 3C, la figure 3D, la figure 3E, la figure 3F, la figure 3G, la figure 3H, la figure 3I, la figure 3J, la figure 3K, la figure 3L, la figure 3M, la figure 3N, la figure 3O, la figure 3P, la figure 3Q, la figure 3R, la figure 3S et la figure 3T représentent un exemple de procédé de fabrication de la puce électronique illustrée en figure 2.

Plus particulièrement, les figures 3A à 3T illustrent un procédé de fabrication simultanée, ou cointégration dans une même puce de circuits intégrés, du circuit mémoire de la puce 110 illustré en figure 2 comportant des cellules mémoire à base d'un matériau à changement de phase et de circuits logiques, adjacents au circuit mémoire, comportant des transistors de trois types différents appelés respectivement GO1, GO2 et GO3. Les transistors de type GO1, GO2 et GO3 diffèrent les uns des autres en particulier par l'épaisseur de leur isolant de grille. Plus particulièrement, les transistors de type GO1 présentent une épaisseur d'isolant de grille inférieure à celle des transistors de type GO2, et les transistors de type GO2 présentent une épaisseur d'isolant de grille inférieure à celle des transistors de type GO3. A titre d'exemple, les transistors GO3 ont une tension d'utilisation comprise entre 3 V et 5 V.

Sur chacune des figures 3A à 3T, on a représenté quatre régions a), b), c) et d) de la puce dans lesquelles sont formées respectivement un transistor de type GO1, un transistor de type GO2, un transistor de type GO3, et une cellule mémoire à base d'un matériau à changement de phase. On comprendra qu'en pratique, la région a) peut comporter plusieurs transistors de type GO1, la région b) peut comporter plusieurs transistors de type GO2, la région c) peut comporter plusieurs transistors de type GO3, et la région d) peut comporter plusieurs cellules mémoire à base d'un matériau à changement de phase.

La figure 3A illustre une structure de départ comportant un substrat conducteur 45. En figure 3A, le substrat 45 comprend quatre régions et plus précisément, une première région a) dans et sur laquelle est formé un transistor de type GO1 au cours du procédé décrit ci-après, une deuxième région b) dans et sur laquelle est formé un transistor de type GO2 au cours du procédé décrit ci-après, une troisième région c) dans et sur laquelle est formé un transistor de type GO3 au cours du procédé décrit ci-après et une quatrième région d) dans et sur laquelle est formée la cellule mémoire au cours du procédé décrit ci-après.

A titre d'exemple, le substrat semiconducteur 45 est en silicium.

A titre d'exemple, le substrat semiconducteur 45 comprend, dans ses première a) et deuxième b) régions une couche d'isolation enterrée 47. La couche 47 est, par exemple, en un oxyde, par exemple en dioxyde de silicium (SiO₂).

A titre d'exemple, le substrat semiconducteur 45 comprend, en outre, dans sa quatrième région d) la couche semiconductrice 13 dopée du type N et la couche semiconductrice 15 dopée du type P.

La structure de départ illustrée en figure 3A comporte, par exemple, des tranchées d'isolation et par exemple les tranchées d'isolation très peu profondes 31 et les tranchées d'isolation peu profondes 43.

A titre d'exemple, des tranchées d'isolation peu profondes 43 sont présentes dans les première a) et deuxième b) régions du substrat 45 et traversent par exemple, la couche d'isolation enterrée 47. A titre d'exemple, les tranchées d'isolation 43 présentes dans les régions a) et b) du substrat 45 permettent de délimiter et d'isoler individuellement les transistors GO1 et GO2 formés dans et sur le substrat 45.

Similairement, des tranchées d'isolation peu profondes 43 sont présentes dans la troisième région c) du substrat 45. A titre d'exemple, les tranchées d'isolation 43 dans la région c) du substrat 45 permettent de délimiter et d'isoler individuellement les transistors GO3 formés dans et sur le substrat 45.

A titre d'exemple, le substrat 45 comprend, en outre, dans sa quatrième région d), des tranchées d'isolation 43 et 31 formant une grille similairement à ce qui a été décrit en relation avec la figure 2.

La figure 3B illustre une structure obtenue à l'issue d'une étape de formation d'une première couche d'isolant de grille 49 sur la face supérieure de la structure illustrée en figure 3A.

Lors de cette étape, la couche 49 est par exemple formée sur et en contact avec la face supérieure du substrat 45. La couche d'isolant de grille 49 s'étend, par exemple, de façon continue sur toute la surface du substrat 45 et notamment sur les quatre régions a), b), c) et d) du substrat 45.

La couche 49 a, par exemple, une épaisseur sensiblement uniforme sur toute la surface du substrat 45. A l'issue de cette étape, la couche d'isolant de grille 49 présente une épaisseur, par exemple comprise entre 6 nm et 16 nm, par exemple comprise entre 7 nm et 15 nm. A titre d'exemple, la couche 49 est en un oxyde, par exemple en oxyde de silicium.

La figure 3C illustre une structure obtenue à l'issue d'une étape de formation d'une couche 51, correspondant à une première couche de grille, sur la face supérieure de la structure illustrée en figure 3B.

Lors de cette étape, la couche 51 est par exemple formée sur et en contact avec la face supérieure de la couche 49. La couche 51 s'étend, par exemple, de façon continue sur toute la surface de la couche 49 et notamment sur les quatre régions a), b), c) et d) du substrat 45. A titre d'exemple, la couche 51 a une épaisseur sensiblement uniforme sur toute la surface de la couche 49. A titre d'exemple, la couche 51 est en silicium, par exemple en silicium polycristallin.

La figure 3D illustre une structure obtenue à l'issue d'une étape de retrait partiel des couches 49 et 51 de la structure illustrée en figure 3C.

A l'issue de l'étape de formation de la couche 51, les couches 49 et 51 sont, par exemple, retirées localement en vis-à-vis des régions a) et b). A titre d'exemple, les couches 49 et 51 sont retirées par gravure. Plus précisément, lors de cette étape, les couches 49 et 51 sont, par exemple, retirées sur toute la surface du vis-à-vis des régions a) et b) de façon à découvrir la face supérieure du substrat 45. A titre d'exemple, à l'issue de cette étape, les couches 49 et 51 subsistent uniquement en vis-à-vis des régions c) et d).

La figure 3E illustre une structure obtenue à l'issue d'une étape de formation d'une deuxième couche d'isolant de grille 53 sur la face supérieure de la structure illustrée en figure 3D.

Lors de cette étape, la couche 53 est par exemple formée sur la face supérieure du substrat 45 en vis à vis des régions a) et b) et sur la face supérieure de la couche 51 en vis-à-vis des régions c) et d). A titre d'exemple, la couche 53 est en contact avec la face supérieure du substrat 45 en vis-à-vis des régions a) et b) et avec la face supérieure de la couche 51 en vis-à-vis des régions c) et d).

La couche d'isolant de grille 49 s'étend, par exemple, de façon continue sur toute la surface du substrat 45 et notamment sur les quatre régions a), b), c) et d) du substrat 45.

La couche 53 a, par exemple, une épaisseur sensiblement uniforme sur toute la surface de la structure illustrée en figure 3D. A l'issue de cette étape, la couche d'isolant de grille 45 présente une épaisseur, par exemple comprise entre 2 nm et 6 nm, par exemple comprise entre 3 nm et 5 nm. A titre d'exemple, la couche 45 est en un oxyde, par exemple en oxyde de silicium.

La figure 3F illustre une structure obtenue à l'issue d'une étape de retrait partiel de la couche 53 de la structure illustrée en figure 3E.

A l'issue de l'étape de formation de la couche 53, celle-ci est, par exemple, retirée localement en vis-à-vis de la région a). A titre d'exemple, la couche 53 est retirée par gravure. Plus précisément, lors de cette étape, la couche 53 est par exemple retirée sur toute la surface du vis-à-vis de la région a) de façon à découvrir la face supérieure du substrat 45. A titre d'exemple, à l'issue de cette étape, la couche 53 subsistent uniquement en vis-à-vis des régions b), c) et d).

La figure 3G illustre une structure obtenue à l'issue d'une étape de formation d'un empilement isolant 55 et d'une couche métallique 56 sur la face supérieure de la structure illustrée en figure 3F.

A titre d'exemple, l'empilement 55 comprend une première couche diélectrique et une deuxième couche diélectrique. Lors de cette étape, l'empilement 55 est, par exemple, formé sur la face supérieure du substrat 45 en vis à vis de la région a) et sur la face supérieure de la couche 53 en vis-à-vis des régions b), c) et d). A titre d'exemple, l'empilement 55 est en contact avec la face supérieure du substrat 45 en vis-à-vis de la région a) et avec la face supérieure de la couche 53 en vis-à-vis des régions b), c) et d) .

A titre d'exemple, la couche métallique 56 est formée sur et en contact avec la face supérieure de l'empilement 55.

Les couches diélectriques de l'empilement 55 et la couche métallique 56 s'étendent, par exemple, de façon continue sur toute la surface du substrat 45 et notamment sur les quatre régions a), b), c) et d) du substrat 45.

Les couches diélectriques de l'empilement 55 ont, par exemple, une épaisseur sensiblement uniforme sur toute la surface de la structure illustrée en figure 3F. A l'issue de cette étape, l'empilement 55 présente une épaisseur, par exemple comprise entre 0,5 nm et 2 nm, par exemple comprise entre 1 nm et 1,5 nm

De plus, la couche métallique 56 a, par exemple, une épaisseur sensiblement uniforme sur toute la surface de la structure illustrée en figure 3F. A l'issue de cette étape, la couche 56 présente une épaisseur, par exemple comprise entre 3 nm et 10 nm, par exemple comprise entre 4 nm et 6 nm.

A titre d'exemple, l'empilement 55 comprend un oxyde, par exemple du dioxyde de silicium.

A titre d'exemple, l'empilement 55 comprend un matériau à haute permittivité, par exemple de l'oxynitrure de silicium hafnium (HfSiON) et/ou de l'oxyde d'hafnium (HfO₂).

A titre d'exemple, la couche 56 est en un nitrure de titane (TiN).

La figure 3H illustre une structure obtenue à l'issue d'une étape de retrait partiel des couches 55, 56 et 53 de la structure illustrée en figure 3G.

A l'issue de l'étape de formation de l'empilement 55 et de la couche 56, ceux-ci, avec la couche 53 sont par exemple retirées localement en vis-à-vis des régions c) et d). A titre d'exemple, les couches 55, 56 et 53 sont retirées gravure. Plus précisément, les couches 55, 56 et 53 sont, lors de cette étape, par exemple retirées sur toute la surface du vis-à-vis des régions c) et d) de façon à découvrir la face supérieure de la couche 51. A titre d'exemple, à l'issue de cette étape, les couches 55, 56 et 53 subsistent uniquement en vis-à-vis des régions a) et b).

La figure 3I illustre une structure obtenue à l'issue d'une étape de formation d'une couche de grille 57 sur la face supérieure de la structure illustrée en figure 3H.

Lors de cette étape, la couche de grille 57 est par exemple formée sur la face supérieure de la couche 56 en vis à vis des régions a) et b) et sur la face supérieure de la couche 51 en vis-à-vis des régions c) et d). A titre d'exemple, la couche 57 est formée en contact avec la face supérieure de la couche 56 en vis-à-vis des régions a) et b) et en contact avec la face supérieure de la couche 51 en vis-à-vis des régions c) et d). La couche de grille 57 s'étend, par exemple, de façon continue sur toute la surface substrat 45 et notamment sur les quatre régions a), b), c) et d) du substrat 45.

La couche de grille 57 a, par exemple, une épaisseur non uniforme sur toute la surface de la structure illustrée en figure 3H, la couche de grille 57 étant, par exemple, plus épaisse en vis-à-vis de la région d) du substrat 45 qu'en vis-à-vis de la région c) du substrat 45. A l'issue de cette étape, la couche de grille 57 présente une épaisseur, par exemple comprise entre 30 nm et 50 nm, par exemple comprise entre 35 nm et 45 nm.

A titre d'exemple, la couche de grille 57 est en silicium, par exemple en silicium polycristallin.

A titre d'exemple, à l'issue de cette étape, la structure comprend :
- un premier empilement de grille, comportant par exemple l'empilement 55, la couche 56 et la couche 57, sur et en contact avec la face supérieure de la première région a) du substrat 45 ;
- un deuxième empilement de grille, comportant par exemple la couche 53, l'empilement 55, la couche 56 et la couche 57, sur et en contact avec la face supérieure de la deuxième région b) du substrat 45 ;
- un troisième empilement de grille, comportant par exemple la couche 49, la couche 51 et la couche 57, sur et en contact avec la face supérieure de la troisième région c) du substrat 45 ; et
- un quatrième empilement, comportant par exemple la couche 49, la couche 51 et la couche 57, sur et en contact avec la face supérieure de la quatrième région d) du substrat 45.

En figure 3I, la structure comporte, en outre, sur la face supérieure de la couche 57, une première couche de masquage 59.

La couche de masquage 59 est par exemple déposée sur et en contact avec la face supérieure de la couche 57. A titre d'exemple, la première couche de masquage 59 est en un oxyde, par exemple en dioxyde de silicium.

La figure 3J illustre une structure obtenue à l'issue d'une étape de gravure de la structure illustrée en figure 3I.

Lors de cette étape, on vient retirer la couche de masquage 59 localement en vis-à-vis de la quatrième région d) du substrat 45 et sur une partie périphérique du vis-à-vis de la troisième région c) du substrat 45.

A titre d'exemple, à l'issue de cette étape, la couche de masquage 59 est présente uniquement en vis-à-vis des régions a) et b) et en vis-à-vis d'une partie centrale de la surface de la région c).

Lors de cette étape, on vient en outre, retirer les parties de la structure non recouvertes par la couche de masquage 59 spar gravure. Lors de cette étape, l'empilement formé en vis-à-vis de la région d) et la partie périphérique de l'empilement formé en vis-à-vis de la région c) sont ainsi retirés par gravure. En d'autres termes, lors de cette étape, les couches 57, 51 et 49 sont retirées en vis-à-vis de la région d) et une partie périphérique de ces mêmes couches sont retirées en vis-à-vis de la région c). A titre d'exemple, les couches susmentionnées sont retirées de façon à dévoiler la face supérieure du substrat 45.

Lors de cette étape, les empilements formés en vis-à-vis des régions a) et b) sont protégées par la couche de masquage 59 et ne sont donc pas gravés.

A l'issue de cette étape, la partie de l'empilement qui subsiste en vis-à-vis de la région c) correspond au motif de grille, comportant la grille et l'isolant de grille, du transistor GO3.

La figure 3K illustre une structure obtenue à l'issue d'une étape de formation d'espaceurs isolants 61 dans la structure illustrée en figure 3J.

A titre d'exemple, lors de cette étape, les espaceurs isolants 61 sont formés de part et d'autre des motifs de grille formés, en vis-à-vis de la région c), lors de l'étape de gravure décrite en relation avec la figure 3J.

Les espaceurs isolants 61 sont, par exemple, en nitrure de silicium (Si_{3M4}).

La figure 3L illustre une structure obtenue à l'issue d'une étape de retrait de la couche de masquage 59 dans la structure illustrée en figure 3K.

A titre d'exemple, lors de cette étape, la couche de masquage 59 est retirée de façon à libérer la face supérieure de la couche 57 dans les régions a), b) et c).

La figure 3M illustre une structure obtenue à l'issue d'une étape de formation d'une deuxième couche de masquage 63 sur la face supérieure de la structure illustrée en figure 3L.

Plus particulièrement, lors de cette étape, la couche de masquage 63 est par exemple formée sur et en contact avec la face supérieure de la couche 57 en vis-à-vis des régions a) et b), sur et en contact avec la face supérieure du substrat 45 en vis-à-vis de la région d) et sur et en contact avec une partie de la face supérieure du substrat 45, sur et en contact avec les flancs des espaceurs 61 et sur et en contact avec la face supérieure de la couche 57 en vis-à-vis de la région c).

A titre exemple, la couche de masquage 63 est en un oxyde.

La figure 3N illustre une structure obtenue à l'issue d'une étape de gravure de la structure illustrée en figure 3M.

Lors de cette étape, on vient plus particulièrement retirer localement la couche 63 sur une partie périphérique du vis-à-vis de la première région a) et sur une partie périphérique du vis-à-vis de la deuxième région b).

A titre d'exemple, à l'issue de cette étape, la couche de masquage 63 est présente uniquement en vis-à-vis des régions c) et d) et en vis-à-vis, seulement d'une partie centrale, de la surface des régions a) et b).

Lors de cette étape, on vient, en outre, retirer par gravure les parties de la structure non recouvertes par la couche de masquage 63 . Lors de cette étape, la partie périphérique de l'empilement formé en vis-à-vis de la région a) et la partie périphérique de l'empilement formé en vis-à-vis de la région b) sont ainsi retirés par gravure. En d'autres termes, lors de cette étape, les couches 57, 55 et 56 sont retirées localement dans la partie périphérique en vis-à-vis de la région a) et les couches 57, 55, 56 et 53 sont retirées localement dans la partie périphérique en vis-à-vis de la région d). A titre d'exemple, les couches susmentionnées sont retirées de façon à dévoiler la face supérieure du substrat 45.

A l'issue de cette étape, les parties des empilements qui subsistent en vis-à-vis des régions a) et b) correspondent aux motifs de grille des transistors GO1 et GO2.

Lors de cette étape, l'empilement formé en vis-à-vis de la région c) est protégé par la couche de masquage 63 et n'est donc pas gravé.

Lors de cette étape, les tranchées d'isolation 31 formées dans la région d) du substrat 45 sont protégées de la gravure par la couche de masquage 63.

La figure 3O illustre une structure obtenue à l'issue d'une étape de formation d'espaceurs isolants 65 dans la structure illustrée en figure 3N.

A titre d'exemple, lors de cette étape, les espaceurs isolants 65 sont formés de part et d'autre des motifs de grille formés, en vis-à-vis des régions a) et b), lors de l'étape de gravure décrite en relation avec la figure 3N. A titre d'exemple, l'empilement formé en vis-à-vis de la région c) étant protégé par la couche de masquage 63, des espaceurs 65 ne se forment pas sur ses flancs.

Les espaceurs isolants 65 sont, par exemple, en nitrure de silicium (Si_{3M4}).

La figure 3P illustre une structure obtenue à l'issue d'une première étape d'épitaxie du substrat 45 de la structure illustrée en figure 3O.

A titre d'exemple, lors de cette étape, les parties, en silicium, libres de la face supérieure de la structure illustrée en figure 3O subissent une épitaxie de façon à former une couche 451 à la surface de la structure illustrée en figure 3O. La couche 451 est, par exemple, formée en vis-à-vis de la région a), entre les tranchées d'isolation 43 et l'empilement formé par les couches 63, 57, 65, 55 et 56 et les espaceurs 65. La couche 451 est en outre, par exemple, formée en vis-à-vis de la région b), entre les tranchées d'isolation 43 et l'empilement formé par les couches 53, 55, 56, 57, 57 et les espaceurs 65.

A titre d'exemple, lors de cette étape, la face supérieure de la région d) du substrat 45 étant protégée par la couche de masquage 63, le substrat 45 dans la région d) ne croît pas en refermant les tranchées d'isolation 31 par leurs faces supérieures.

La figure 3Q illustre une structure obtenue à l'issue d'une étape de formation d'espaceurs isolants 67 dans la structure illustrée en figure 3P.

A titre d'exemple, lors de cette étape, les espaceurs isolants 67 sont formés de part et d'autre des motifs de grille formés, en vis-à-vis des régions a) et b). A titre d'exemple, l'empilement formé en vis-à-vis de la région c) étant protégé par la couche de masquage 63, des espaceurs 67 ne se forment pas sur ses flancs.

Les espaceurs isolants 67 sont, par exemple, en nitrure de silicium (Si_{3M4}).

La figure 3R illustre une structure obtenue à l'issue d'une deuxième étape d'épitaxie de la couche 451 de la structure illustrée en figure 3Q.

Plus particulièrement, lors de cette étape, les parties, en silicium, libres de la face supérieure de la structure illustrée en figure 3Q subissent, par exemple, une épitaxie de façon à former une couche 453 à la surface de la structure illustrée en figure 3Q. La couche 453 est ainsi par exemple formée en vis-à-vis de la région a), entre les tranchées d'isolation 43 et l'empilement formé par les couches 63, 57, 65, 55 et 56 et les espaceurs 65 et 67. La couche 451 est en outre, par exemple, formée en vis-à-vis de la région b), entre les tranchées d'isolation 43 et l'empilement formé par les couches 53, 55, 56, 57, 57 et les espaceurs 65 et 67.

Similairement à ce qui a été décrit en relation avec la première étape d'épitaxie, la face supérieure de la région d) du substrat 45 étant protégée par la couche de masquage 63, le substrat 45 dans la région d) ne croît pas en refermant les tranchées d'isolation 31.

La figure 3S illustre une structure obtenue à l'issue d'une étape de retrait de la couche de masquage 63 et de siliciure de la structure illustrée en figure 3R.

Plus particulièrement, lors de cette étape, les parties, en silicium, libres de la structure illustrée en figure 3R se voient, par exemple, siliciurées sur une partie supérieure.

Une couche 69 est ainsi, par exemple, formée dans une partie supérieure de la couche 57 et dans une partie supérieure de la couche 453 en vis-à-vis de la région a), dans une partie supérieure de la couche 57 et dans une partie supérieure de la couche 453 en vis-à-vis de la région b), dans une partie supérieure de la couche 57 et dans une partie supérieure du substrat 45 en vis-à-vis de la région c) et dans une partie supérieure du substrat 45 en vis-à-vis de la région d). A titre d'exemple, la couche 69 n'est pas formée à l'aplomb des tranchées d'isolation 43 et 31. A titre d'exemple, la couche 69 est en siliciure de nickel (NiSi).

La figure 3T illustre une structure obtenue à l'issu d'une étape de formation du circuit mémoire de la puce 110 dans et sur le substrat 45 dans sa quatrième région d). A titre d'exemple, la formation du circuit mémoire comprend des étapes d'implantation des zones 25 et 27, de formation des vias 39 et 29, et de formation des points ou cellules mémoire M à base d'un matériau à changement de phase. Ces étapes n'ont pas été détaillées, les modes de réalisation décrits étant compatibles avec les procédés connus de réalisation de cellules mémoire à base d'un matériau à changement de phase.

Par rapport à la structure des figures 1A et 1B, un avantage des modes de réalisation décrits est que le retrait des motifs de grille 17 de la zone de formation des cellules mémoire à base d'un matériau à changement de phase permet de réduire les courants de fuite au sein du circuit mémoire.

Un autre avantage des modes de réalisation décrits est qu'ils tirent profit du masque 63 de protection de l'empilement de grille des transistors GO3 pour protéger la surface de la région de formation des cellules mémoire pendant la gravure de l'empilement de grille des transistors GO1 et GO2.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, les modes de réalisation décrits ne se limitent pas aux exemples de matériaux et de dimensions mentionnés dans la présente description.

Enfin, la mise en oeuvre pratique des modes de réalisation et variantes décrits est à la portée de la personne du métier à partir des indications fonctionnelles données ci-dessus.

## Revendications

1. Procédé comprenant la formation simultanée, dans et sur un substrat semiconducteur (45) :
- d'un premier transistor d'un premier type (GO1) dans et sur une première région (a)) du substrat semiconducteur ;
- d'un deuxième transistor d'un deuxième type (GO2) dans et sur une deuxième région (b)) du substrat semiconducteur ;
- d'un troisième transistor d'un troisième type (GO3) dans et sur une troisième région (c)) du substrat semiconducteur ; et
- d'une cellule mémoire à base d'un matériau à changement de phase dans et sur une quatrième région (d)) du substrat semiconducteur,
le procédé comprenant, les étapes successives suivantes :
a) formation de tranchées d'isolation (43, 31) dans la quatrième région (d)) du substrat semiconducteur ;
b) formation :
- d'un premier empilement de grille sur et en contact avec la première région (a)) du substrat semiconducteur,
- d'un deuxième empilement de grille sur et en contact avec la deuxième région (b)) du substrat semiconducteur,
- d'un troisième empilement de grille sur et en contact avec la troisième région (c)) du substrat semiconducteur, et
- d'un quatrième empilement, sur et en contact avec le substrat semiconducteur en vis-à-vis de la quatrième région (d)) du substrat semiconducteur ;
c) graver simultanément une partie du troisième empilement de grille et le quatrième empilement de façon à découvrir le substrat semiconducteur (45) dans sa quatrième région, le premier empilement de grille et le deuxième empilement de grille étant protégés par un premier masque (59) ; et
f) graver simultanément le premier et le deuxième empilement de grille, le troisième empilement de grille et la quatrième région du substrat semiconducteur (45) étant protégés par un deuxième masque (63).

2. Procédé selon la revendication 1, dans lequel le quatrième empilement est identique au troisième empilement de grille.

3. Procédé selon la revendication 1 ou 2, comportant, après l'étape f), des étapes d'épitaxie du substrat semiconducteur (45) en vis-à-vis des première et deuxième régions du substrat semiconducteur (45), le troisième empilement de grille et la quatrième région (d)) du substrat semiconducteur étant protégés par le deuxième masque (63).

4. Procédé selon l'une quelconque des revendications 1 à 3, dans lequel le troisième empilement de grille comprend une première couche d'isolant de grille (49) et une couche de grille (57).

5. Procédé selon l'une quelconque des revendications 1 à 4, dans lequel le premier empilement de grille comprend un empilement diélectrique (55), une couche métallique (56) et une couche de grille (57).

6. Procédé selon l'une quelconque des revendications 1 à 5, dans lequel le deuxième empilement de grille comprend un deuxième couche d'isolant de grille (53), un empilement diélectrique (55), une couche métallique (56) et une couche de grille (57).

7. Procédé selon la revendication 5 ou 6, dans lequel l'empilement diélectrique (55) comporte une première couche diélectrique et une deuxième couche diélectrique, la deuxième couche diélectrique étant en un matériau de haute permittivité.

8. Procédé selon l'une quelconque des revendications 1 à 7, dans lequel les tranchées isolantes (43, 31) sont remplies d'un oxyde.

9. Procédé selon l'une quelconque des revendications 1 à 8, comportant une étape de formation de cellules mémoires dans et sur le substrat semiconducteur (45) en vis-à-vis de la quatrième région (d)) du substrat semiconducteur (45).

10. Puce électronique (110) formée dans et sur un substrat semiconducteur, comportant un circuit mémoire comportant une première couche semiconductrice (23) disposée sur et en contact avec une deuxième couche semiconductrice (13) dopée d'un premier type de conductivité (N), elle-même située sur et en contact avec une troisième couche semiconductrice (15) dopée d'un deuxième type de conductivité (P) opposé au premier type de conductivité (N), la première couche semiconductrice (23) comportant des zones (25) dopées du deuxième type de conductivité,
le circuit mémoire comportant des tranchées (31) délimitant les zones (25) de la première couche semiconductrice (23), et s'étendant à partir d'une face de la première couche semiconductrice (23) opposée à la deuxième couche semiconductrice (13), à travers la première couche semiconductrice (23) et débouchant dans la deuxième couche semiconductrice (13), et
les zones (25) de la première couche semiconductrice (23) étant surmontées par des points mémoires (M) à base de matériau à changement de phase (33), la deuxième couche (13), la troisième couche (15) et les zones (25) de la première couche (23) constituant des transistors bipolaires (T1),
la puce électronique (110) comprenant en outre un premier transistor d'un premier type (GO1) ayant une première épaisseur d'isolant de grille dans et sur une première région (a)) du substrat semiconducteur, un deuxième transistor d'un second type (GO2) ayant une deuxième épaisseur d'isolant de grille différente de la première épaisseur de grille dans et sur une deuxième région (b)) du substrat semiconducteur, un troisième transistor d'un troisième type (GO3) ayant une troisième épaisseur d'isolant de grille différente des première et deuxième épaisseurs d'isolant de grille dans et sur une troisième région (c)) du substrat semiconducteur,
dans laquelle la puce électronique ne comprend pas de motif de grille au-dessus des tranchées (31).
